# EUROPEAN PATENT APPLICATION

(11) **EP 3 641 067 A1**
(43) Date of publication of application: **22.04.2020**
(21) Application number: 19191024.9
(22) Date of filing: 09.08.2019
(51) Int. Cl.: H01R 12/71, H01R 13/405, H01R 12/58, H01R 12/70, H01R 12/72

(54) **PIN HEADER**

(30) Priority: 19.10.2018 TW 107136949; 19.10.2018 TW 107214174 U; 19.10.2018 TW 107214175 U
(71) Applicant: Quan Mei Technology Co. Ltd, 82059 Kaohsiung City (TW)
(72) Inventor: CHOU, Kuang-Hui, Kaohsiung City (TW); HSIAO, Yu-Hsuan, Kaohsiung City (TW)
(74) Representative: Broderick, Terence

(57) **Abstract**

A pin header (200) includes a plurality of pins (4) and a seat body (3) having a base portion (31) and an extending portion (32) . The extending portion (32) has a connecting end (323) connected to the base portion (31) and having a cross section that overlaps a portion of and that is within a surface of the base portion (31) . Each of the pins (4) has a securing segment (41) having a main portion (411) and at least one protruding portion (412) that protrudes transversely from the main portion (411) . The extending portion (32) of the seat body (3) is formed with a plurality of spaced-apart internal receiving spaces (320), each of which corresponds in shape to and is engaged fittingly with the securing segment (41) of a respective one of the pins (4) so that the pins (4) are secured to the seat body (3).

## Description

The disclosure relates to a pin header, more particularly to a pin header adapted to be installed on a circuit board of an electronic device.

A circuit board of an electronic device is adapted to be mounted with many electronic components. In order to easily install and uninstall these electronic components, a plurality of pin headers may be electrically connected to the circuit board for the electronic components to be electrically connected to. A conventional pin header includes a columnar or L-shaped electrically insulating seat body and a plurality of electrically conductive pins extending through and fixed to the seat body.

For the pin header having a columnar seat body, the pins are straight rods, so repeated installation and removal of the electronic component may cause the pins to loosen from the seat body (e.g., to move along a longitudinal direction of the pins relative to the seat body), or even cause the pin header to detach entirely from the circuit board.

In order to secure the pin header to the circuit board, first the pin header is placed on the circuit board with the pins being inserted into holes in the circuit board, then the circuit board and the pin header are sent through a solder stove so that the pins are fixedly connected to the circuit board. However, since the holes in the circuit board are generally larger than the dimensions of a cross section of the pins, in the process of transferring the circuit board and the pin header to the soldering stove, the pins are only loosely inserted in the holes and the pin header is likely to tilt or tip over, which would affect the yield of the assembly of the circuit board and the conventional pin header.

Therefore, the object of the disclosure is to provide a pin header that can alleviate at least one of the drawbacks of the prior art.

According to the disclosure, a pin header is adapted to be installed on a circuit board. The pin header includes a seat body made of an electrically insulating material, and a plurality of electrically conductive pins extending through the seat body.

The seat body has a base portion and an extending portion. The base portion is plate-shaped, and has a first surface adapted for abutting against a surface of the circuit board, and a second surface opposite to the first surface. The extending portion extends from the second surface of the base portion, and has a connecting end that is connected to the base portion and a distal end that is opposite to the connecting end. A cross section of the connecting end overlaps a portion of and is within the second surface of the base portion. The extending portion is formed with a plurality of spaced-apart internal receiving spaces.

Each of the pins has a connecting segment that protrudes from the distal end of the extending portion of the seat body, and a securing segment that has a main portion and at least one protruding portion protruding transversely from the main portion. Each of the receiving spaces of the seat body corresponds in shape to and is engaged fittingly with the securing segment of a respective one of the pins so that the pins are secured to the seat body.

Other features and advantages of the disclosure will become apparent in the following detailed description of the embodiments with reference to the accompanying drawings, of which:
FIG. 1 is a fragmentary exploded perspective view of a circuit board mounted with a plurality of first embodiments of a pin header according to the disclosure;
FIG. 2 is a perspective view of the first embodiment;
FIG. 3 is a sectional view of the first embodiment;
FIG. 4 is a sectional view of a second embodiment of the pin header according to the disclosure;
FIG. 5 is a fragmentary exploded perspective view of a circuit board mounted with a plurality of third embodiments of the pin header according to the disclosure;
FIG. 6 is a perspective view of the third embodiment;
FIG. 7 is a fragmentary exploded perspective view of a circuit board mounted with a plurality of fourth embodiments of the pin header according to the disclosure; and
FIG. 8 is a perspective view of the fourth embodiment.

Before the present invention is described in greater detail, it should be noted that where considered appropriate, reference numerals or terminal portions of reference numerals have been repeated among the figures to indicate corresponding or analogous elements, which may optionally have similar characteristics.

To aid in describing the disclosure, directional terms may be used in the specification to describe portions of the present disclosure (e.g., front, rear, left, right, top, bottom, etc.). These directional definitions are intended to merely assist in describing the disclosure and are not intended to limit the disclosure in any way.

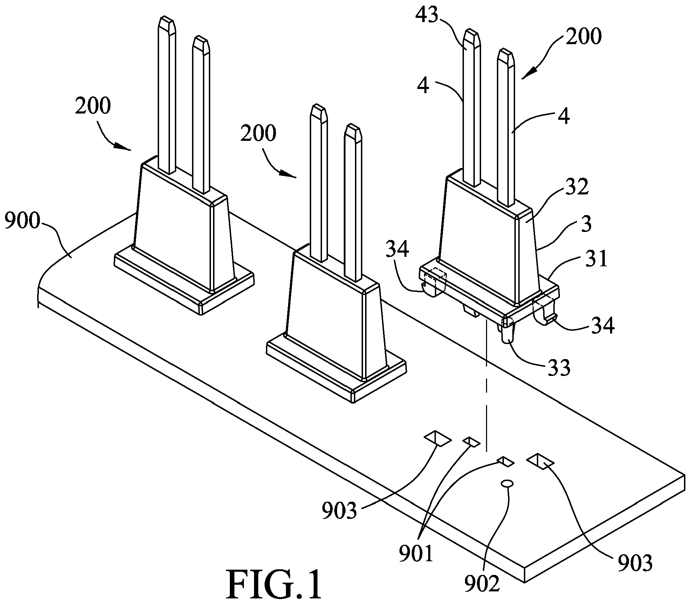

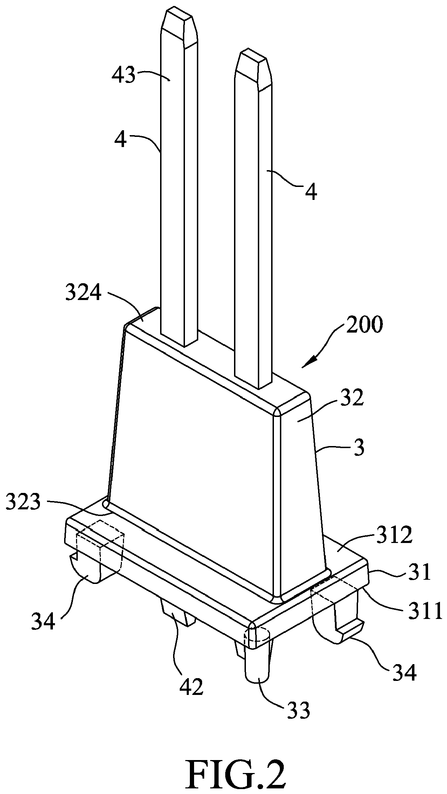

Referring to FIGS. 1 to 3, a first embodiment of a pin header 200 according to this disclosure is adapted to be installed on a circuit board 900. The circuit board 900 is formed with a plurality of board-connecting holes 901, a plurality of positioning holes 902 (only one shown) and a plurality of securing holes 903. The pin header 200 includes a seat body 3 made of an electrically insulating material, and a plurality of electrically-conductive pins 4. In this embodiment, the pin header 200 includes two of the pins 4.

The seat body 3 has a plate-shaped base portion 31, an extending portion 32, a positioning portion 33, and two securing portions 34. The quantities of the position portion 33 and the securing portion 34 are not limited thus and may vary in other embodiments. In certain embodiments, the positioning portion 33 and the securing portion 34 may be completely omitted.

The base portion 31 has a first surface 311 adapted for abutting against a surface of the circuit board 900, and a second surface 312 opposite to the first surface 311.

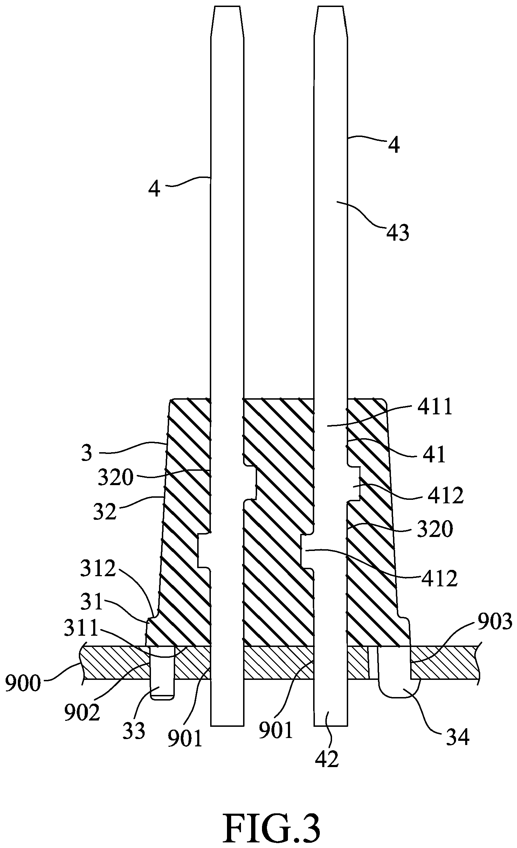

The extending portion 32 extends from the second surface 312 of the base portion 31, and has a connecting end 323 connected to the base portion 31 and a distal end 324 opposite to the connecting end 323. A cross section of the connecting end 323 overlaps a portion of and is within the second surface 312 of the base portion 31. In this embodiment, the width of each of the left and right sides of the connecting end 323 is smaller than that of the base portion 31, while the width of each of the front and rear sides of the connecting end 323 is substantially equal to that of the base portion 31, but the width of each side of the connecting end 323 of the extending portion 32 may be smaller than that of the base portion 31 in other embodiments. The extending portion 32 is formed with a plurality of spaced-apart internal receiving spaces 320 (see FIG. 3). In this embodiment, the extending portion 32 is formed with two receiving spaces 320 respectively corresponding to the two pins 4.

The positioning portion 33 extends from the first surface 311 of the base portion 31, and is adapted for insertion into one of the positioning holes 902 in the circuit board 900.

The two securing portions 34 extends from the first surface 311 of the base portion 31, and are adapted for respectively extending through two of the securing holes 903 in the circuit board 900. Each of the securing portions 34 has a hook end that is adapted for abutting against an end surface (i.e., the bottom surface as illustrated in FIG. 3) of the circuit board 900.

The pins 4 extend through the seat body 3. Each of the pins 4 has a securing segment 41, a plug segment 42 protruding from the first surface 311 of the base portion 31 of the seat body 3, and a connecting segment 43 protruding from the distal end 324 of the extending portion 32 of the seat body 3. The securing segment 41 is connected between the connecting segment 43 and the plug segment 42.

The securing segment 41 has a main portion 411 and at least one protruding portion 412 that protrudes transversely from the main portion 411.

In this embodiment, the main portion 411 of the securing segment 41 is straight and elongated, and the securing segment 41 includes two of the protruding portions 412 protruding from different positions on the main portion 411. In variations of this embodiment, the protruding portions 412 may protrude symmetrically from opposite positions on the main portion. The cross section of the protruding portions 412 may have the shape of a semicircle, a triangle, a rectangle, or other polygons. Each of the receiving spaces 320 of the seat body 3 corresponds in shape to and is engaged fittingly with the securing segment 41 of a respective one of the pins 4 so that the pins 4 are secured to the seat body 3.

The plug segment 42 is adapted for insertion into a corresponding one of the board-connecting holes 901 to be electrically connected to the circuit board 900.

When installing the pin header 200 onto the circuit board 900, the plug segments 42 of the pins 4 and the positioning portion 33 of the seat body 3 are inserted respectively into the corresponding board-connecting holes 901 and the positioning hole 902. At the same time, the securing portions 34 of the seat body 3 are inserted through the respective securing holes 902 until the hook ends of the securing portions 34 abut against the end surface of the circuit board 900, thus respectively engaging the securing portions 34 with the securing holes 902. Since the cross section of the connecting end 323 overlaps a portion of and is within the second surface 312 of the base portion 31, the pin header 200 has a wider base which allows it to sit more stably on the circuit board 900. Coupled with the insertion of the positioning portion 33 and securing portions 34 into the circuit board 900, the pin header 200 is stably secured to the circuit board 900, and less likely to detach in the process of passing through a soldering stove, which increases the yield of the assembly of the pin header 200 and the circuit board 900.

Furthermore, the respective and fitting engagement between the receiving spaces 320 of the seat body 3 and the securing segments 41 of the pins 4 reduces the likelihood of the pins 4 moving relative to or detaching from the seat body 3.

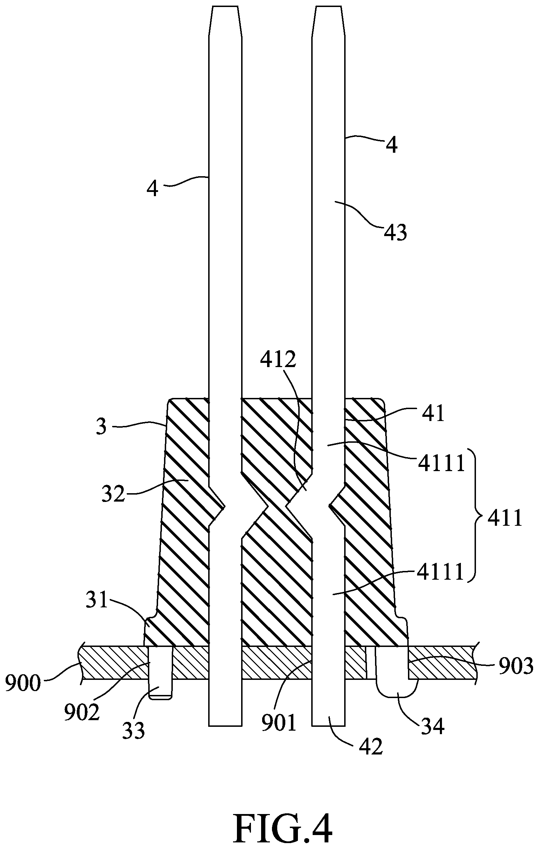

Referring to FIG. 4, a second embodiment of the pin header 200 according to the disclosure is similar to the first embodiment, but differs from the first embodiment in the structure of the securing segment 41 of each of the pins 4.

In the second embodiment, the securing segment 41 of each of the pins 4 includes one protruding portion 412 having at least two sections that are not collinear, and the main portion 411 of the securing segment 41 has two elongated subportions 4111, the protruding portion 412 being connected between the elongated subportions 4111. In this embodiment, the protruding portion 412 has two non-collinear sections forming a V-shaped structure, but the protruding portion 412 may has two curved sections forming a U-shaped structure, or four sections forming a saw tooth-shaped structure.

In this embodiment, the protruding portion 412 is positioned near the middle of the main portion 411, but in variations of this embodiment, the protruding portion 412 may be positioned adjacent to the plug segment 42 or the connecting segment 43, and the main portion 411 may include only one elongated subportion 4111.

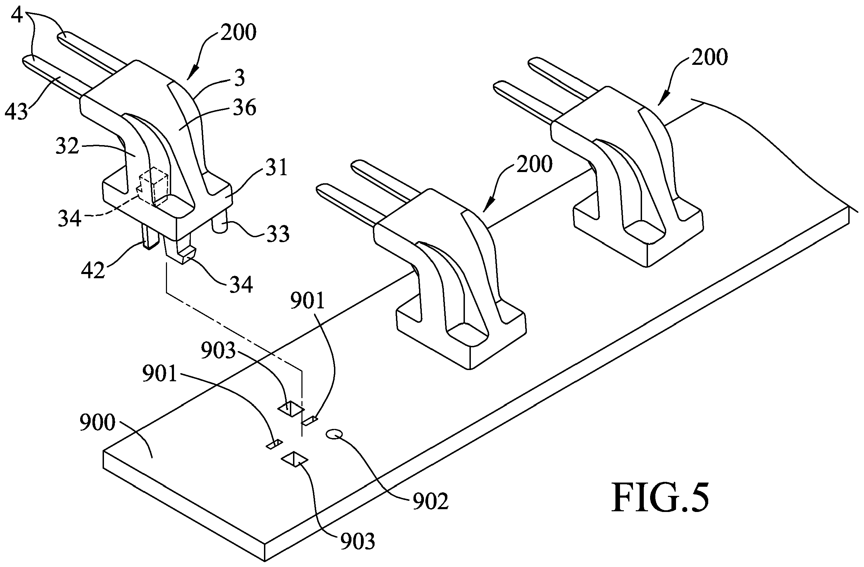

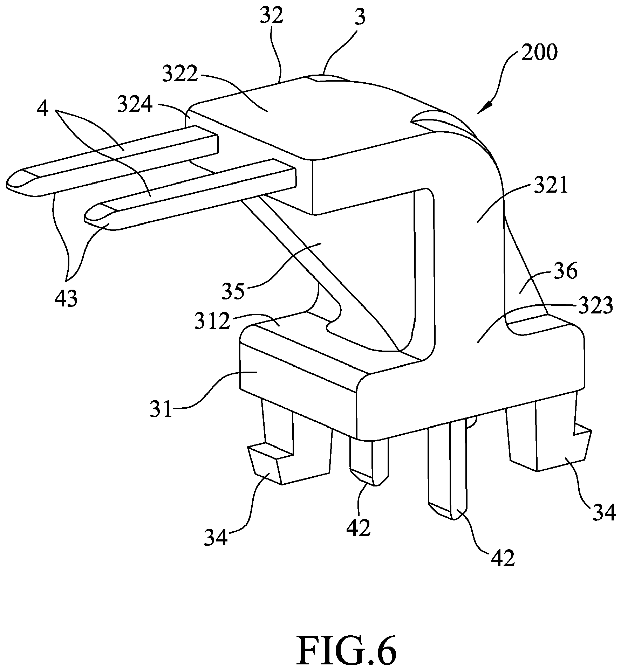

Referring to FIGS. 5 and 6, a third embodiment of the pin header 200 is similar to the first embodiment but differs in the structure of the seat body 3 and the pins 4.

In the third embodiment, the extending portion 32 and the pins 4 are L-shaped, and the seat body 3 further has an inner rib 35 and an outer rib 36.

The extending portion 32 has a first extending section 321 and a second extending section 322. The first extending section 321 is substantially perpendicular to the second surface 312 of the base portion 31, and has an end which serves as the connecting end 323 of the extending portion 32. The second extending section 322 is substantially perpendicular to the first extending section 321, extends from a distal end of the first extending section 321, and has an end which serves as the distal end 324 of the extending portion 32. Each of the pins 4 is an L-shaped pin extending through the first and second extending sections 321, 322. In a variation of this embodiment, the seat body 3 may have the same overall shape as in the first embodiment, and the connecting segments 43 of the L-shaped pins 4 extend out of one of the left, right, front and rear sides of the seat body 3.

The inner rib 35 is connected between the second surface 312 of the base portion 31 and a surface of the extending section 32 which is proximal to the base portion 31 (i.e., the surface connecting the lower side of the second extending section 322 and the left side of the first extending section, as illustrated in FIG. 6). The outer rib 36 is connected between the second surface of the base portion 31 and a surface of the extending portion 32 which is distal from the base portion 31 (i.e., the surface connecting the upper side of the second extending section 322 and the right side of the first extending section, as illustrated in FIG. 6). In this embodiment, the thickness of the inner and outer ribs 35, 36 are smaller than a width of corresponding sides of the extending portion 32, but may be equal to the width of the corresponding sides of the extending portion 32 in other embodiments.

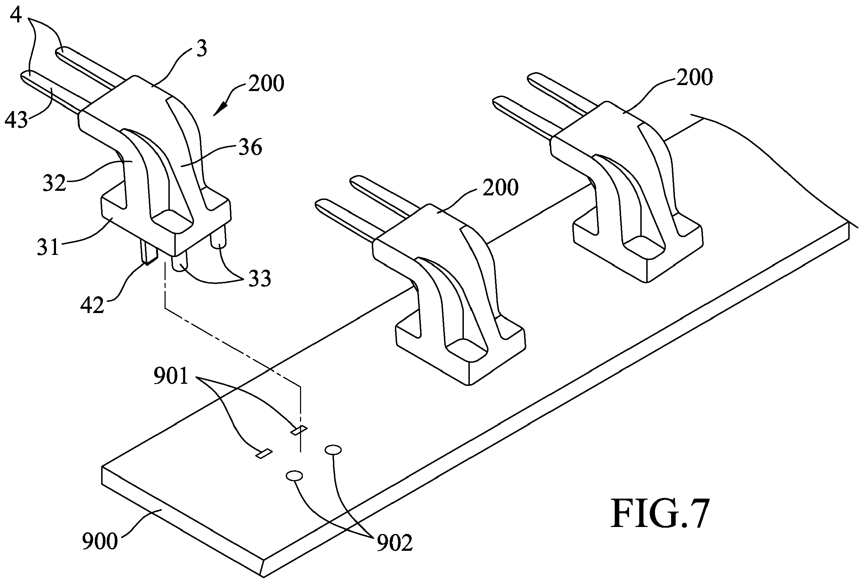

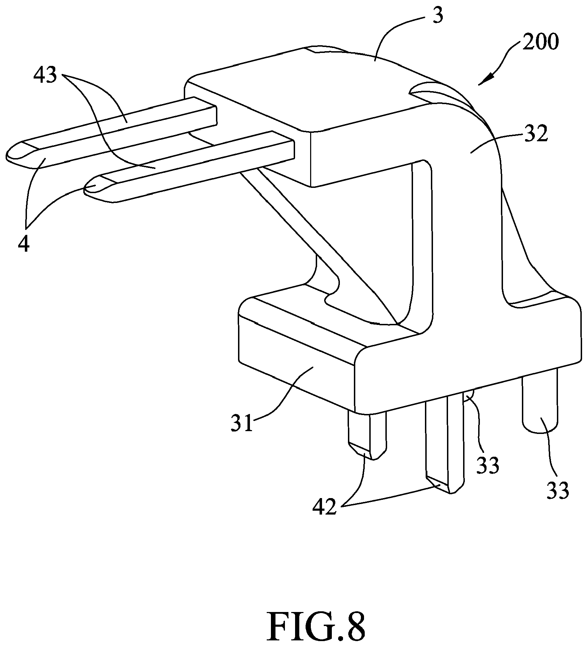

Referring to FIGS. 7 and 8, a fourth embodiment of the pin header 200 is similar to the third embodiment, but differs in that the securing portions 34 are omitted and the seat body 3 includes two of the positioning portions 33.

In the description above, for the purposes of explanation, numerous specific details have been set forth in order to provide a thorough understanding of the embodiments. It will be apparent, however, to one skilled in the art, that one or more other embodiments may be practiced without some of these specific details. It should also be appreciated that reference throughout this specification to "one embodiment," "an embodiment," an embodiment with an indication of an ordinal number and so forth means that a particular feature, structure, or characteristic may be included in the practice of the disclosure. It should be further appreciated that in the description, various features are sometimes grouped together in a single embodiment, figure, or description thereof for the purpose of streamlining the disclosure and aiding in the understanding of various inventive aspects, and that one or more features or specific details from one embodiment may be practiced together with one or more features or specific details from another embodiment, where appropriate, in the practice of the disclosure.

## Claims

1. A pin header (200) adapted to be installed on a circuit board (900), **characterized by**:
a seat body (3) made of an electrically insulating material, and having
a base portion (31) that is plate-shaped, and that has a first surface adapted for abutting against a surface of the circuit board (900), and a second surface opposite to said first surface, and
an extending portion (32) extending from said second surface of said base portion (31), said extending portion (32) having a connecting end (323) that is connected to said base portion (31) and a distal end (324) that is opposite to said connecting end (321), a cross section of said connecting end (323) overlapping a portion of and being within said second surface of said base portion (31), said extending portion being formed with a plurality of spaced-apart internal receiving spaces (320); and
a plurality of electrically conductive pins (4) extending through said seat body (3), each of said pins (4) having a connecting segment (43) that protrudes from said distal end (324) of said extending portion (32) of said seat body (3) and a securing segment (41) that has a main portion (411) and at least one protruding portion (412) protruding transversely from said main portion (411), each of said receiving spaces (320) corresponding in shape to and being engaged fittingly with said securing segment (41) of a respective one of said pins (4) so that said pins (4) are secured to said seat body (3).

2. The pin header as claimed in claim 1, **characterized in that** said main portion (411) of said securing segment (41) of each of said pins (4) is elongated.

3. The pin header as claimed in claim 1 or claim 2, **characterized in that** said at least one protruding portion (412) of said securing segment (41) of each of said pins (4) has at least two sections that are not collinear.

4. The pin header as claimed in claim 3, further **characterized in that**, for each of said pins (4), said main portion (411) of said securing segment (41) has two elongated subportions (4111), said at least one protruding portion (412) being connected between said elongated subportions (4111).

5. The pin header (200) as claimed in any one of the previous claims, **characterized in that**:
said extending portion (32) of said seat body (3) is L-shaped, and has
a first extending section (321) having an end which serves as said connecting end (323) of said extending portion (32), and being perpendicular to said second surface of said base portion (31), and
a second extending section (322) being substantially perpendicular to said first extending section (321), extending from a distal end of said first extending section (321), and having an end which serves as said distal end (324) of said extending portion (32) ; and
each of said pins (4) is an L-shaped pin extending through said first and second extending sections (321, 322).

6. The pin header (200) as claimed in claim 5, further **characterized in that** said seat body (3) further has an inner rib (35) connected between said second surface of said base portion (31) and a surface of said extending portion (32) which is proximal to said base portion (31).

7. The pin header (200) as claimed in claim 5 or claim 6, further **characterized in that** said seat body (3) further has an outer rib (36) connected between said second surface of said base portion (31) and a surface of said extending portion (32) which is distal from said base portion (31).

8. The pin header (200) as claimed in any one of the previous claims, **characterized in that** said seat body (3) further has a positioning portion (33) extending from said first surface of said base portion (31), and adapted for insertion into a positioning hole (902) which is formed in the circuit board (900).

9. The pin header as claimed in any one of the previous claims, **characterized in that** said seat body (3) further has a securing portion (34) extending from said first surface of said base portion (31), adapted for extending through a securing hole (903) which is formed in the circuit board (900), and having a hook end that is adapted for abutting against an end surface of the circuit board (900).

10. The pin header as claimed in any one of the previous claims, **characterized in that** each of said pins (4) further has a plug segment (42) protruding from said first surface of said base portion (31) and adapted for insertion into a board-connecting hole (901) which is formed in the circuit board (900) to be electrically connected to the circuit board (900), said securing segment (41) being connected between said connecting segment (43) and said plug segment (42).
